(19) Europäisches Patentamt
European Patent Office
Office européen des brevets

(11) EP 0 487 819 B1

(12) **EUROPEAN PATENT SPECIFICATION**

(45) Date of publication and mention
of the grant of the patent:
**05.03.1997 Bulletin 1997/10**

(51) Int Cl.6: **G11C 7/00**, G11C 11/409

(21) Application number: **91109300.3**

(22) Date of filing: **06.06.1991**

(54) **Video random access memory with fast, alligned clear and copy**

Video-RAM mit schnellen Rücksetzung und Kopiermöglichkeit

Vidéo RAM à initialisation et réécriture alignées rapides

(84) Designated Contracting States:
**DE FR GB**

(30) Priority: **31.10.1990 US 607197**

(43) Date of publication of application:
**03.06.1992 Bulletin 1992/23**

(73) Proprietor: **International Business Machines Corporation**
**Armonk, N.Y. 10504 (US)**

(72) Inventors:
• **Elsner, Matthew**
**Woodstock, New York 12498 (US)**
• **Gupta, Satish**
**Peekskill, New York 10566 (US)**

• **Peters West, Roderick Michael**
**Chandlers Ford, Hampshire SO5 1TG (US)**
• **Williams, Todd**
**Westford, Vermont 05494 (US)**

(74) Representative: **Schäfer, Wolfgang, Dipl.-Ing.**
**IBM Deutschland**
**Informationssysteme GmbH**
**Patentwesen und Urheberrecht**
**70548 Stuttgart (DE)**

(56) References cited:
**EP-A- 0 371 488**          **US-A- 4 663 735**

• **ELECTRONIC DESIGN. vol. 38, no. 10, May 1990, HASBROUCK HEIGHTS, NEW JERSEY pages 37 - 43 BURSKY 'TRIPLE-PORT DYNAMIC RAM ACCELERATES DATA MOVEMENT'**

## Description

BACKGROUND OF THE INVENTION

Field of the Invention

The present invention generally relates to video memory circuits and, more particularly, to enhancements to achieve very fast, aligned clear and copy write operations in such memory circuits. The invention has particular application for memory used in video frame buffers and all points addressable (APA) or bit mapped page buffers.

Description of the Prior Art

Interactive computer graphics provides a natural way for a user to communicate with a computer; however, creating and reproducing a meaningful display on, for example, a cathode ray tube (CRT) presents many problems which have been solved in a variety of ways, using both software and hardware. In most applications, a dynamically changing display is required. Operations such a scrolling, pan and zoom are supported by most graphics applications, and graphics user interfaces (GUI) now routinely implement some form of windowing. Algorithms have been developed to implement these operations. One such example is the Cohen-Sutherland clipping algorithm which efficiently identifies those lines that can be trivially accepted or rejected using region checks. Clipping is an important operation for windowing and zoom operations. A description of this and other interactive computer graphics operations may be had by reference to the text book by J.D. Foley and A. Van Dam entitled <u>Fundamentals of Interactive Computer Graphics</u>, Addison-Wesley (1984).

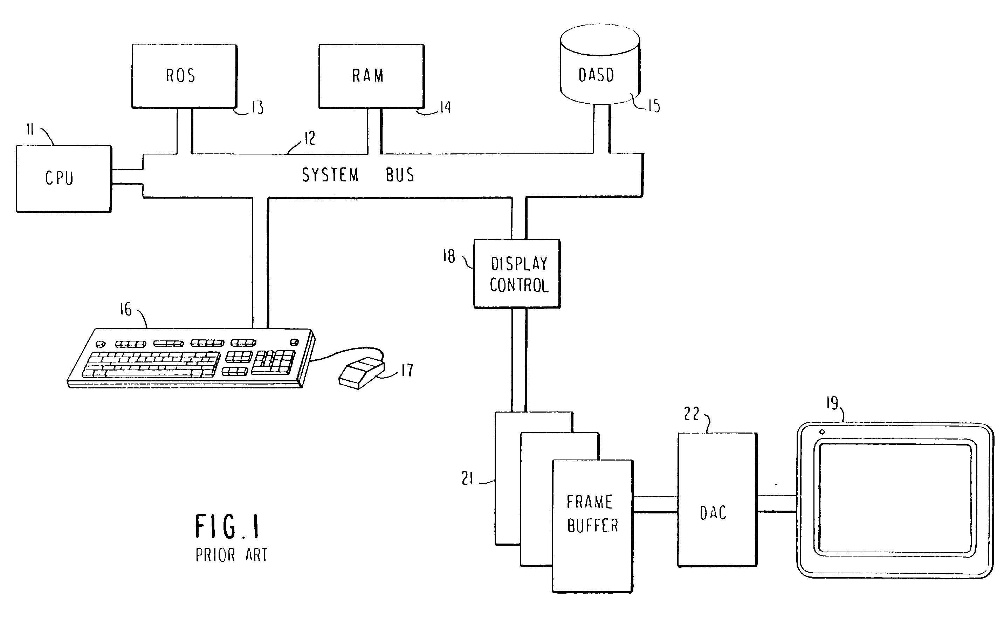

Fig. 1 shows a high level block diagram of hardware of a typical interactive computer graphics system. A central processing unit (CPU) 11 is connected to a system bus 12 to which are attached various supporting devices. These include a read only storage (ROS) 13, which stores the basic input/output system (BIOS) of the CPU 11, and a random access memory (RAM) 14, in which are loaded the control and application programs to be run on the CPU 11. Typically, the control program is stored and "booted" (i.e., read into RAM 14) from a direct storage access device (DASD) 15 such as a hard disk drive. The application program, such a graphics program, may also be stored on the DASD 15. The user input to the system is typically by means of a keyboard 16 and a pointing device such as a mouse 17. A display controller 18 is connected to the system bus 12 and responds to control signals from the CPU 11 to generate the data which is ultimately displayed on a CRT display 19. The controller typically includes one or more microprocessors dedicated to performing the computationally intensive tasks required of modern day interactive computer graphics systems. This relieves the CPU 11 of those tasks, speeding up performance. The display data is stored in frame buffers 21 in digital form. These buffers include dynamic RAMs or DRAMs having a bi-directional parallel port allowing for refreshing and updating the display data by the controller 18. Such video memories are often referred to as VRAMs. The buffers 21 also include a serial register and a serial access port allowing row data in the RAM array to be serially output from the buffers. The very high quality color displays used in today's systems are analog devices; therefor, a digital to analog converter (DAC) 22 is interposed between the frame buffers 21 and the CRT display 19.

The software solutions implemented in the past generally resulted in relatively slow performance. As a result, there has been an effort to improve performance by implementing many graphics operations in hardware. Depending on the designer's orientation, these hardware implementations may be in the controller 18, the frame buffers 21 or the DAC 22. The present invention is specifically directed to improvements in VRAM architecture as used in the frame buffers 21.

There are several examples of VRAMs in the prior art which include both RAM ports and serial ports. U.S. Patent No. 4,649,516 to Chung et al. describes a dynamic row buffer for a DRAM chip wherein the row buffer can be loaded in parallel and read out serially. The row buffer is isolated from the memory array for use in graphics applications allowing the chip to be used as dual port VRAM.

U.S. Patent No. 4,663,729 to Matick et al. describes a VRAM display architecture which supports a variable, selectable number of bits per chip and a variable, selectable segment width. This architecture is specifically designed to control spill and wrap functions of CRT scan line data from the memory when used as a graphics frame buffer.

U.S. Patent No. 4,812,836 to Kurakake et al. describes a method of image translation performed while transferring data between two frame buffer serial access memory (SAM) ports, each of which are capable of address offset. The resulting translated image, located in the second SAM, is then stored for display.

U.S. Patent No. 4,745,577 to Ogawa et al. describes a memory array with multiple serial registers each of which has separate input and output ports and can transfer data, in parallel, between registers for high speed read/write of cathode ray tube (CRT) display data.

U.S. Patent No. 4,644,502 to Kawashima describes a method of reading or writing successive memory address locations from one or more serial registers automatically. It employs a row increment circuit to provide the next address location for operation between the random access memory (RAM) and serial register to be performed whenever the update port is not being accessed by the central processing unit (CPU). Each of the serial registers have separate input and output ports and data can be transferred in parallel between them.

U.S. Patent No. 4,755,810 to Knierim describes a RAM frame buffer organized into tiles with row/column address increment/decrement circuitry, a FIFO and barrel shifter to facilitate scrolling in the horizontal and vertical directions. It also contains the logic circuitry to perform Boolean operations on data stored in the serial register for high speed pixel (picture element) alteration and image update.

While the prior art provides dual ports for accessing the random memory access array and the serial register, data modification is primarily accomplished via the random port. Data access, however, is faster via the serial port.

In the journal ELECTRONIC DESIGN, vol. 38, no. 10, May 1990, Hasbrouck Heights, New Jersey, pages 37- 43, D. Bursky: "Triple-Port dynamic RAM accelerates DATA Movement", a video RAM is disclosed wherein a serial port for data transfer of a memory array to a serial memory is bi-directional to provide for partial aligned data transfer or mask write back. Thus the speed for subsequent partial write operations is enhanced.

It is an object of the present invention to provide a video random access memory which, with minor modifications provides grater flexibility in the modification and update of data in the RAM array.

The invention is characterized in claim 1. Further improvements of the invention are featured in the dependent claims.

The invention and improvements also meet advantageously the following objects:

It is another object of the invention to provide hardware enhancements to a video random access memory that facilitates partial but aligned data transfers from a serial access memory to a random access memory array.

It is a further object of the invention to provide a video random access memory structure that Improves serial access memory data input/output operations for the random access memory array.

Improved serial access memory data input operations, for subsequent random access memory update, is accomplished by means of a register source of "0s" or "Is" for an aligned clear operation, a random port or on-chip ALU data fill of the SAM on aligned or unaligned boundaries at serial clock or page mode cycles, and serial port input to the SAM from another chip serial port or a serial or parallel load from an additional on-chip serial port or register. The serial port can also provide row data for ALU input at serial clock speeds for on-chip read-modify-write operations, with modified data returned to the SAM for aligned memory writeback. Aligned SAM transfers from one row to another rows can be performed for scrolling or windowing.

In the architecture according to the invention, data received by the SAM has already been processed by a mask register. The partial write back is the aligned boundary which is controlled by decoding and align registers in the SAM and transfer gates.

BRIEF DESCRIPTION OF THE DRAWINGS

The foregoing and other objects, aspects and advantages will be better understood from the following detailed description of a preferred embodiment of the invention with reference to the drawings, in which:

Fig. 1 is a block diagram of a typical interactive computer graphics system;

Fig. 2 is a block showing the video random access memory architecture according to the present invention;

Fig. 3 is a simplified block diagram illustrating the partial but aligned transfers from the serial access memory to random access memory according to the invention; and

Fig. 4 is a simplified block diagram similar to Fig. 3 showing two serial access memories, one of which incorporates the enhancements to improve memory array write capability according to the invention and the other performs CRT refresh, parallel transfer from SAM to SAM and serial input.

DETAILED DESCRIPTION OF PREFERRED EMBODIMENTS OF THE INVENTION

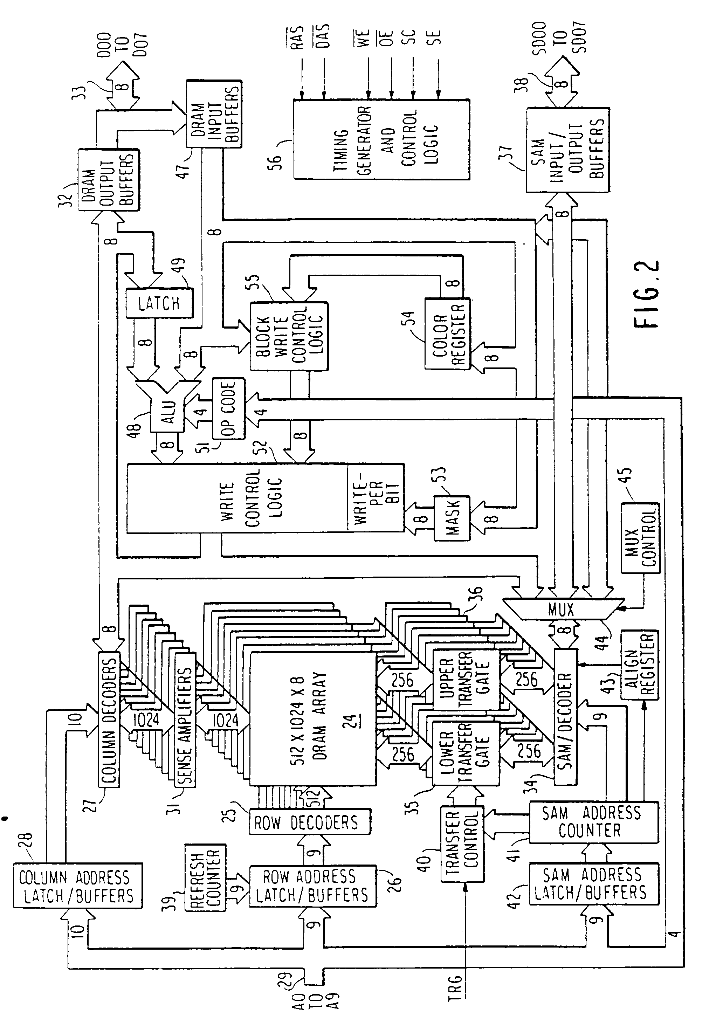

Referring now to the drawings, and more particularly to Fig. 2, there is shown a dynamic random access memory (DRAM) array 24 which is composed of eight planes of 512x1024 storage devices arranged in addressable rows and columns. A row decoder 25 is responsive to row address data in a row address buffer 26 to generate a row address for a selected row in the array 24. A column decoder 27 is responsive to column address data in a column address buffer 28 to generate a range of column addresses. Both the row address buffer 26 and the column address buffer 28 are loaded via an address port 29. Data may be read out of the DRAM array 24, sensed by the sense amplifiers 31 and supplied via the column decoders 27 to the DRAM output buffers 32 and then to the parallel or random port 33. As will be explained in more detail later, the random port 33 is a bi-directional port. The architecture thus far described is conventional and functions in a well known manner.

In addition to the DRAM array 24, a serial access memory (SAM) and decoder 34 is provided, and data may be read in parallel from the DRAM array 24 to the SAM/decoder 34 via lower and upper transfer gates 35 and 36, respectively. There are 1024 bits in a row of each plane of the DRAM array 24 for the example shown, and there are 1024 transfer gates for each plane of the DRAM array. To maintain both update and refresh performance, the SAM/decoder 34 may require split register transfer operation during CRT (cathode ray tube) scan time (referred to as midline reload) or during an external load operation with limited memory update bandwidth; therefore, it is advantageous to divide these 1024 gates into two groups of 256 transfer gates, referred to as the lower and upper transfer gates. Once loaded, the data in the SAM/decoder 34 can be transferred via SAM input/output buffers 37 to the serial port 38. The serial port 38, like the random port 33, is bidirectional as will be described in more detail hereinafter. As described above, it is now conventional to provide a serial output register and a separate serial port, especially in VRAM chips. Since the principle application of this architecture is for video displays, a refresh counter 39 is provided to cycle the row addresses in the row address buffer 26. This is also a conventional feature.

The present invention contemplates that data may be read into the DRAM array 24 from the SAM/decoder 34 as well as read out of the DRAM array 24 to the SAM/decoder 34 and thence to the serial port 38. To that end, the lower and upper transfer gates 35 and 36 are bidirectional. Transfer of data between the DRAM array 24 and the SAM/decoder 34 is controlled by transfer control logic 40 in response to a transfer gate control signal, TRG. The direction of transfer is controlled by the write enable (WE) signal. There is additionally provided a SAM address counter 41 which is responsive to a SAM address buffer 42 to select a starting address or an address range in the SAM/decoder 34 and increments the serial register address every serial clock (SC) cycle. The SAM address buffer 42, like the row address buffer 26 and the column address buffer 28, is loaded from the address port 29. Transfer control logic 40 is also responsive to SAM address counter 41 to activate only those transfer gates within the addressed range of the SAM/decoder 34. The data read into SAM/decoder 34 may be specified by a starting address and a width or, alternatively, a start address and a stop address. This is controlled by the align register 43 which is loaded from the SAM address counter 41.

Data also may be read into the selected address range of the SAM/decoder 34 via a multiplexer 44 which is a bi-directional three-to-one multiplexer. That is, data may be read into SAM/decoder 34 from any one of three sources or read out of the SAM to either one of three destinations. The data paths and direction are controlled by multiplexer control 45. One of the input paths is common to the output path already described; i.e., from the serial port 38 to the SAM input/output buffers 37 and via multiplexer 44 to SAM/decoder 34. Another input path is directly from the write control logic 52 which includes data from ALU operations and the random input port which has been masked as required, to be written into the SAM/decoder 34. The third input path is from the random port 33 to the input buffers 47 and via multiplexer 44 to the SAM/decoder 34.

In the preferred embodiments of the invention, various logic units and registers are integrated on the chip providing very flexible operation. As mentioned, the random port 33 is bi-directional. Data input to random port 33 is temporarily stored in DRAM input buffers 47 from where it may be loaded by several on-chip logic units and registers. The data from DRAM input buffers 47 may be loaded as one operand to the arithmetic logic unit (ALU) 48. The other operand is supplied by latch 49 which temporarily stores data read out of the DRAM array 24. Thus, the data in the DRAM array 24 may be modified and read back into the array. The operation performed by the ALU 48 is controlled by an operation code (opcode) read into register 51 from the address port 29. The output of the ALU 48 is provided to a write control logic 52 the output of which is connected to the path from the column decoders 27 to the multiplexer 44. The write control logic 52 is conventional and formats data consistent with the operation performed. For example, the write control logic 52 may format data according to the contents of mask register 53, which is loaded from the DRAM input buffers 47. Data in the DRAM input buffers 47 may also be read into a color register 54. The output of the color register 54 is supplied to block write control logic 55. Block write control logic 55 is actually part of write control logic 52 and is also conventional. It is shown separately to illustrate the interface provided to color register 54. Note that block write control logic 55 may be loaded directly from the DRAM input buffers 47. Note that the mask register 53, the color register 54 and the block write control logic may be loaded from the SAM/decoder 34 via multiplexer 44, further extending the flexibility of this architecture.

For the sake of simplicity, the timing generator and control logic 56 is shown as a single block with a plurality of inputs. These include the row address strobe, $\overline{RAS}$, the column address strobe, $\overline{CAS}$, the write enable, $\overline{WE}$, output enable, $\overline{OE}$, serial clock, SC, and serial enable, SE, signals. These are basically conventional and are used by the timing generator and control logic to generate the required timing and control signals for the several components of the VRAM.

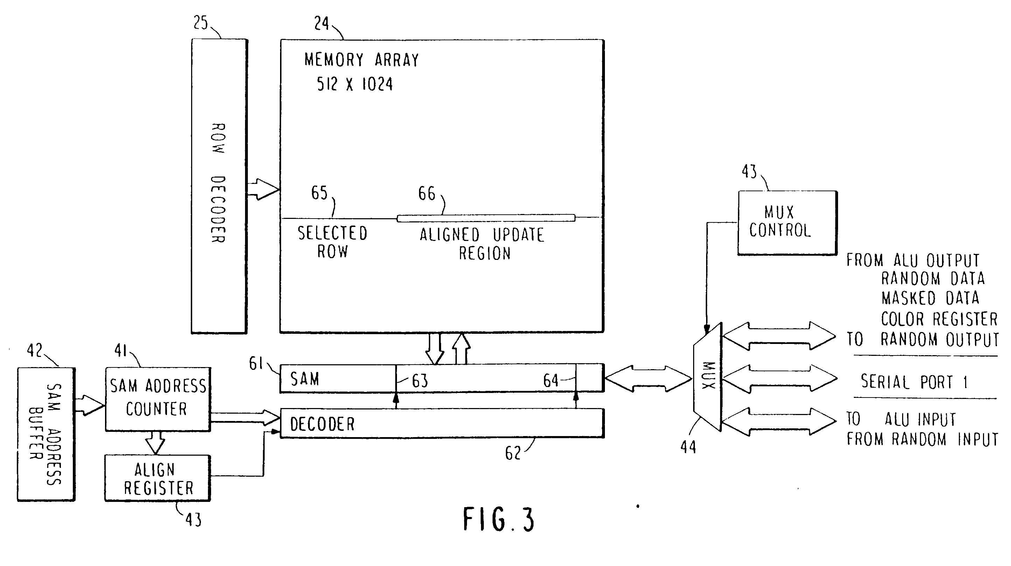

Fig. 3 shows in simplified form the DRAM array 24 and the SAM/decoder 34. For the sake of simplicity, only a single plane of the DRAM array 24 is illustrated, but this is sufficient to illustrate the operations performed by the new VRAM architecture of the present invention. The SAM/decoder 34 is shown as comprising a serial access memory (SAM) 61 and a decoder 62. The SAM address buffer 42 provides an output to the SAM address counter 41 which defines a "start" address and a width of an aligned update. The SAM address counter 41 passes the "start" address to the decoder 62 and counts a number of addresses, from the "start" address, corresponding to the width of the aligned update. This produces a "stop" address which is supplied to the align register 43. The align register 43 passes the "stop" address to the decoder 62. The "start" and "stop" addresses are illustrated in the example shown by the marks 63 and 64, respectively, in the SAM 61.

Meanwhile, the address for the row in which the partial, but aligned, update is to be performed is output by the row decoder 25. In the illustrated example, the selected row is called out by reference numeral 65 and, within that row, the aligned update region is called out by reference numeral 66. Thus, the data between "start" and "stop" addresses, denoted by reference numerals 63 and 64 in SAM 61, is used to update that portion of the row in the DRAM array 24 denoted by reference numeral 65.

As previously mentioned, the data for the update is read into SAM 61 via the multiplexer (MUX) 44. As shown in Fig. 2, that data first of all might come via the write control logic 52 from the ALU 48 which performs a selected operation on data read out of the DRAM array 24 and data supplied via the random data port 33 or it might come from the color register 54 via block write control logic 55. The data may be masked by register 53. Secondly, the data may be supplied via the serial data port 38 or, thirdly, directly from the random data port 33.

Note also, as shown in Fig. 3, data may be read into SAM 61 from the DRAM array 24, and this read out of data may be on aligned boundaries as determined by the "start" and "stop" addresses supplied by SAM address counter 41 and align register 43. Data may be read from SAM 61 via multiplexer 44 to anyone of three destinations. Firstly, data may be read directly to the random port 33 via DRAM output buffers 32. Secondly, data may be read directly to the serial data port 38 via SAM input/output buffers 37. And thirdly, data may be read to the ALU 48 as one operand. The serial data read out of the serial data port may be supplied to a display device (e.g., CRT), it may also be supplied to the serial data port of another VRAM chip, allowing for rapid transfer of data between chips.

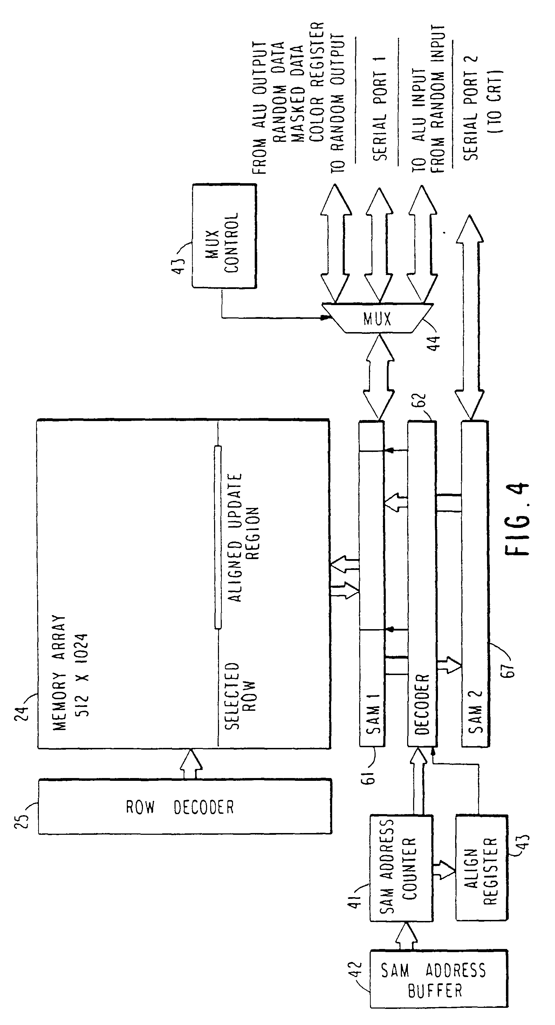

While the SAM 61 can be used for both flexible input/output (I/O) operations to the DRAM array 24 and the read out of serial data to the display device, it may be advantageous in some applications to provide separate SAMs for these two functions. This is illustrated in Fig. 4 where a second SAM 67. Notice that data may be transferred in parallel between the SAM 61 and the SAM 67. Otherwise, the connections for the SAM 61 remain the same. The SAM 67 is connected to a second serial data port, here denoted as serial port 2, and it is from this port that serial data is read to the display device. Thus, data manipulation and transfer is primarily the function of SAM 61, while read out of serial data to a display device is primarily the function of SAM 67. This function of SAM 67 is known in the prior art; however, what is not known in the prior art is the bi-directional nature of the serial port 2 allowing serial data to be transferred to SAM 67 for parallel loading of SAM 61, greatly enhancing the flexibility of the VRAM according to the invention.

The features added by the invention provide the following advantages over the prior art:

1. Copy, clear and scroll operations in either full screen or windowed display modes - An aligned partial write back between column locations corresponds to window boundaries on a scan line. DRAM row updates are made from the SAM 34 filled with "0s" or "1s".

2. Window clipping assist - A partial write back is used to clip images outside window or screen due to pan or zoom operations.

3. Pipelined ALU raster operations - The ALU 48 reads data from the SAM 61, combines that data with the RAM port 33 data and writes into the SAM 61 in pipelined cycles for later write transfer.

4. Color expansion - The color register 54 contents are loaded in to the block write control logic 55 on pixel bit boundaries based on an input data stream at random port 33.

5. Polygon area fill - The color register 54 or mask register 53 contents are used by the write control logic 52 to load the SAM 61 between specified column addresses.

6. Block data update - This provides bounded color expansion, and the SAM data is masked or column limited for writing into selected rows.

As shown in Fig. 3, a row 65 has been selected for update between "start" and "stop" column addresses as specified by data in SAM address counter 41 and align register 43. SAM data between the selected limits is used to update the corresponding bits in the aligned update region of the selected row, all other row data remaining unchanged. SAM contents may be loaded from a previously selected row or copied into another row for scrolling. Other algorithms and graphics operations, such as window clipping, clear, copy and polygon area fill, can be assisted in a similar manner. Control signals invoke this update mode. Column address need only be specified for changes, and normal full row or split register operations are not precluded by this hardware enhancement.

To fully utilize this aligned update feature, fast SAM loading is necessary. This is accomplished by interfacing to the on-chip ALU 48 performing raster operations using memory data from the SAM 61 and RAM port data and writing back to the SAM 61. The color register 54 contents may be used to load the SAM 61 on a pixel basis. A source of "0s" and "1s" to the SAM, either connected to the random port 33 or from the color register 54, can be used to load the SAM 61 for selective clear or area fill into several row locations in DRAM array 24. The SAM 34 allows for sequential high speed write operations at processor speeds or at serial clock cycles as well as on-chip data manipulation and minimum use of array accesses, increasing frame buffer bandwidth over conventional designs using page mode.

The invention thus provides enhanced serial register operations in a video random access memory (VRAM). Specifically, the invention provides aligned (partial) or masked write of data into the DRAM array 24 and fast loading of the SAM 61 from color and mask registers and random port data, ALU or other internal source I/O. These enhancements permit the operations of aligned clear, copy, scrolling, window clipping assist, pipelined ALU operations, color expansion and polygon area fill. Unique to the invention are the masking of serial data and/or high speed loading of the serial register from alternate sources, including one or more serial data ports, in support of these functions.

While the invention has been described in terms of preferred embodiments, those skilled in the art will recognize that the invention can be practiced with modification within the scope of the appended claims.

**Claims**

1. Video random access memory including a video random access memory array (24), a bi-directional random port communicating with said random access memory array (24), a serial access memory (37) connected to receive row data from said random access memory array (24) for outputting serial data to a display device via a serial port (38), wherein

said serial port (38) is bi-directional and said serial access memory ( 37) is connected to said random access memory array (24) to provide for partial but aligned data transfer or mask write-back of data from an on-chip or external source for subsequent partial write operations in said random access memory array (24); and

means (40) are provided for controlling partial but aligned transfers from said serial access memory ( 37) to said random access memory array (24) by a data transfer into an aligned update region of said random access memory array (24),

characterized in that

said update region is located between specified column addresses of a selected row of said random access memory array (24),

sense amplifiers (31) are provided for reading data from said random access memory array (24) to said bi-directional random port,

bi- directional multiplexer means (44) are provided connected between said serial access memory ( 37) and said sense amplifiers (31) and bi- directional serial port (38) for establishing data input paths to said serial access memory ( 37) from said sense amplifiers (31) or said bi-directional serial port (38) or an output from said serial access memory ( 37) to said random port or to said serial port (38); and

multiplexer control means (45) connected to said multiplexer means (44) for selecting a data path and direction of data flow.

2. Memory of claim 1, characterized by

input buffer means (47) connected to said random port for temporarily storing input data;

latch means (28) connected to said sense amplifiers (31) for temporarily storing data read out of said random access memory array (24);

arithmetic logic unit means (48) connected to receive data temporarily stored in said input buffer means (47) and latch means for modifying said data read out of said random access memory array (24);

and means for reading said modified data into said serial access memory (47) via said multiplexer means (44).

3. Memory of claim 2, characterized by operation code register means (51) connected to said address port for receiving and temporarily storing an operation code, said arithmetic and logic unit means (48) being responsive to said operation code for modifying said data read out of said random access memory array (24).

4. Memory according to anyone of claims 1 to 3, characterized by

color register means (54) loaded from said bi-directional random port; and

means for reading data from said color register means (54) into said serial access memory (37) via said multiplexer means (44).

5. Memory according to anyone of claims 1 to 4, characterized by mask register means (53) loaded from said bi-directional random port, data in said mask register means masking data read into said serial access memory (37) via said multiplexer means (44).

6. Memory according to anyone of claims 1 to 5, characterized by

serial address counter means connected to said serial access memory (37) corresponding to said specific column addresses of a selected row of said random access memory array,

align register means connected to said serial access memory (37) for controlling with said serial access memory address counter means a range of addresses addressed in said serial access memory (37).

## Patentansprüche

1. Video-Direktzugriffsspeicher mit einem Video-Direktzugriffsspeicher-Array (24), einem bidirektionalen Direktzugriffsport, der mit dem genannten Direktzugriffsspeicher-Array (24) kommuniziert, einem Speicher mit seriellem Zugriff (37), der so angeschlossen ist, daß er von dem genannten Direktzugriffsspeicher-Array (24) Reihendaten empfängt, um über einen seriellen Port (38) serielle Daten an eine Anzeigevorrichtung auszugeben, bei dem

der genannte serielle Port (38) bidirektional ist und der genannte Speicher mit seriellem Zugriff (37) an das genannte Direktzugriffsspeicher-Array (24) angeschlossen ist, um einen partiellen, jedoch ausgerichteten Datentransfer oder ein maskiertes Zurückschreiben von Daten aus einer direkt auf dem Chip befindlichen oder externen Quelle bereitzustellen, für nachfolgende partielle Schreiboperationen in dem genannten Direktzugriffsspeicher-Array (24); und bei dem

Mittel (40) bereitgestellt werden zur Steuerung eines partiellen, jedoch ausgerichteten Transfers aus dem genannten Speicher mit seriellem Zugriff (37) in den genannten Direktzugriffsspeicher-Array (24), durch einen Datentransfer in einen ausgerichteten Aktualisierungsbereich des genannten Direktzugriffsspeicher-Arrays (24),

dadurch gekennzeichnet, daß

der genannte Aktualisierungsbereich zwischen spezifizierten Spaltenadressen einer ausgewählten Reihe des genannten Direktzugriffsspeicher-Arrays (24) liegt,

Abtastverstärker (31) bereitgestellt werden, um Daten aus dem genannten Direktzugriffsspeicher-Array (24) in den bidirektionalen Direktzugriffsport zu lesen,

bidirektionale Multiplexer-Mittel (44) bereitgestellt werden, die zwischen dem genannten Speicher mit seriellem Zugriff (37) und den genannten Abtastverstärkern (31) und dem bidirektionalen, seriellen Port (38) angeschlossen sind, um Dateneingabepfade zu dem genannten Speicher mit seriellem Zugriff (37) von den genannten Abtastverstärkern (31) oder dem genannten bidirektionalen, seriellen Port (38) oder einen Ausgang von dem genannten Speicher mit seriellem Zugriff (37) zu dem genannten Direktzugriffsport oder zu dem genannten seriellen Port (38) einzurichten; und

Multiplexer-Steuermittel (45), die mit dem genannten Multiplexer-Mittel (44) verbunden sind, zum Auswählen eines Datenpfads und einer Richtung für den Datenfluß.

2. Speicher nach Anspruch 1, gekennzeichnet durch

Eingangspuffermittel (47), die mit dem genannten Direktzugriffsport verbunden sind, um Eingangsdaten vorübergehend zu speichern;

Latch-Mittel (28), die mit den genannten Abtastverstärkern (31) verbunden sind, um aus dem genannten Direktzugriffsspeicher-Array (24) ausgelesene Daten vorübergehend zu speichern;

Arithmetik-Logik-Einheiten (48), die so angeschlossen sind, daß sie die in dem genannten Eingangspuffermittel (47) und dem Latch-Mittel vorübergehend gespeicherten Daten empfangen, um die genannten aus dem genannten Direktzugriffsspeicher-Array (24) ausgelesenen Daten zu modifizieren;

und Mittel, um über das genannte Multiplexer-Mittel (44) die genannten modifizierten Daten in den genannten Speicher mit seriellem Zugriff (47) einzulesen.

3. Speicher nach Anspruch 2, gekennzeichnet durch Operationscode-Registermittel (51), die an den genannten Adreßport zum Empfang und zur vorübergehenden Speicherung eines Operationscodes angeschlossen sind, wobei das genannte Arithmetik-Logik-Einheit-Mittel (48) auf den genannten Operationscode reagiert und die genannten, aus dem genannten Direktzugriffspeicher-Array (24) ausgelesenen Daten modifiziert.

4. Speicher nach einem der Ansprüche 1 bis 3, gekennzeichnet durch

Farbregistermittel (54), die aus dem genannten bidirektionalen Direktzugriffsport geladen werden; und

Mittel, um über das genannte Multiplexer-Mittel (44) Daten aus dem genannten Farbregistermittel (54) in den genannten Speicher mit seriellem Zugriff (37) einzulesen.

5. Speicher nach einem der Ansprüche 1 bis 4, gekennzeichnet durch
Maskenregistermittel (53), die von dem genannten bidirektionalen Direktzugriffsport geladen werden, Daten in dem genannten Maskenregistermittel, welche Daten, die über das genannte Multiplexer-Mittel (44) in den genannten Speicher mit seriellem Zugriff (37) eingelesen werden, maskieren.

6. Speicher nach einem der Ansprüche 1 bis 5, gekennzeichnet durch

serielle Adressenzählmittel, die mit dem genannten Speicher mit seriellem Zugriff (37) verbunden sind, entsprechend den genannten spezifischen Spaltenadressen einer ausgewählten Reihe des genannten Direktzugriffsspeicher-Arrays,

Ausrichtregistermittel, die mit dem genannten Speicher mit seriellem Zugriff (37) verbunden sind, um mit dem genannten Adressenzählmittel des seriellen Zugriffsspeichers einen Bereich von Adressen zu steuern, die in dem genannten seriellen Zugriffsspeicher (37) adressiert werden.

**Revendications**

1. Mémoire vidéo à accès aléatoire comportant un réseau (24) de mémoire vidéo à accès aléatoire, un accès aléatoire bidirectionnel communiquant avec ledit réseau (24) de mémoire à accès aléatoire, une mémoire (37) à accès série connectée pour recevoir des données de rangée en provenance du réseau (24) de mémoire à accès aléatoire pour délivrer des données série vers un dispositif d'affichage par l'intermédiaire d'un accès série (38), dans lequel

ledit accès série (38) est bidirectionnel et ladite mémoire (37) à accès série est connectée audit réseau (24) de mémoire à accès aléatoire pour fournir un transfert de données partiel mais aligné ou une réécriture de masque de données à partir d'une source sur puce ou extérieure pour des opérations ultérieures d'écriture partielle dans ledit réseau (24) de mémoire à accès aléatoire; et

des moyens (40) sont utilisés pour commander les transferts partiels mais alignés à partir de ladite mémoire (37) à accès série vers ledit réseau (24) de mémoire à accès aléatoire par un transfert de données dans une région de mise à jour alignée dudit réseau (24) de mémoire à accès aléatoire,

caractérisée en ce que

ladite région de mise à jour est située entre des adresses de colonne spécifiées d'une rangée sélectionnée dudit réseau (24) de mémoire à accès aléatoire,
des amplificateurs de lecture (31) sont utilisés pour lire des données à partir dudit réseau (24) de mémoire à accès aléatoire vers ledit accès aléatoire bidirectionnel,
des moyens multiplexeurs (44) bidirectionnels sont utilisés connectés entre ladite mémoire (37) à accès série et lesdits amplificateurs de lecture (31) et un accès série bidirectionnel (38) pour établir des trajets d'entrée de données vers ladite mémoire (37) à accès série à partir desdits amplificateurs de lecture (31) ou dudit accès (38) série bidirectionnel ou une sortie de ladite mémoire (37) à accès série vers ledit accès aléatoire ou ledit accès série (38); et
un moyen (45) de commande de multiplexeur connecté audit moyen multiplexeur (44) pour sélectionner un trajet de données et la direction du flux de données.

2. Mémoire selon la revendication 1, caractérisée par

un moyen (47) formant tampon d'entrée connecté audit accès aléatoire pour stocker temporairement des données d'entrée;
un moyen de verrouillage (28) connecté auxdits amplificateurs de lecture (31) pour stocker temporairement des données lues dans ledit réseau (24) de mémoire à accès aléatoire;
un moyen (48) formant unité arithmétique et logique connecté pour recevoir des données stockées temporairement dans ledit moyen (47) formant tampon d'entrée et un moyen de verrouillage pour modifier lesdites données lues dans ledit réseau (24) de mémoire à accès aléatoire;
et un moyen pour lire lesdites données modifiées dans ladite mémoire (47) à accès série par l'intermédiaire dudit moyen multiplexeur (44).

3. Mémoire selon la revendication 2, caractérisée par un moyen (51) formant registre de code opérationnel connecté audit accès d'adresse pour recevoir et stocker temporairement un code opérationnel, ledit moyen (48) formant unité arithmétique et logique étant sensible audit code opérationnel pour modifier lesdites données lues dans ledit réseau (24) de mémoire à accès aléatoire.

4. Mémoire selon l'une quelconque des revendications 1 à 3, caractérisée par

un moyen (54) formant registre de couleur chargé à partir dudit accès aléatoire bidirectionnel; et
un moyen pour lire des données en provenance dudit moyen (54) formant registre de couleur dans ladite mémoire (37) à accès série par l'intermédiaire dudit moyen multiplexeur (44).

5. Mémoire selon l'une quelconque des revendications 1 à 4, caractérisée par
un moyen (53) formant registre de masque chargé à partir dudit accès aléatoire bidirectionnel, des données dans le moyen formant registre de masque masquant les données lues dans ladite mémoire (37) à accès série par l'intermédiaire dudit moyen multiplexeur (44) .

6. Mémoire selon l'une quelconque des revendications 1 à 5, caractérisée par

un moyen formant compteur d'adresse série connecté à ladite mémoire (37) à accès série correspondant auxdites adresse de colonne spécifique d'une rangée sélectionnée dudit réseau de mémoire à accès aléatoire,
un moyen formant registre d'alignement connecté à ladite mémoire (37) à accès série pour commander avec ledit moyen formant compteur d'adresse de mémoire à accès série une plage d'adresses adressées dans ladite mémoire (37) à accès série.

FIG.1
PRIOR ART

FIG.2

EP 0 487 819 B1

FIG.3

FIG. 4